# EUROPEAN PATENT APPLICATION

(11) **EP 2 650 059 A1**
(43) Date of publication of application: **16.10.2013**
(21) Application number: 11846119.3
(22) Date of filing: 08.12.2011
(51) Int. Cl.: B21B 3/02, B21B 1/40, C21D 1/26, C21D 1/74, C22C 38/00, C22C 38/22, C22C 38/40, H01L 31/04

(54) **STEEL FOIL FOR SOLAR CELL SUBSTRATE, SOLAR CELL SUBSTRATE, SOLAR CELL, AND METHODS FOR MANUFACTURING THE STEEL FOIL AND THE SOLAR CELL**

(30) Priority: 10.12.2010 JP 2010275653; 01.12.2011 JP 2011263517
(71) Applicant: JFE Steel Corporation, Tokyo 100-0011 (JP)
(72) Inventor: YAMAGUCHI, Yasuhiro, Tokyo 100-0011 (JP); HONDA, Atsutaka, Tokyo 100-0011 (JP); NISHIYAMA, Naoki, Tokyo 100-0011 (JP)
(74) Representative: Stebbing, Timothy Charles
(86) International application number: PCT/JP2011/078981
(87) International publication number: WO 2012/077827

(57) **Abstract**

The present invention provides a steel foil for a solar cell substrate in which buckling is unlikely to occur even when the steel foil is applied to a solar cell roll-to-roll continual process, and a method for manufacturing the same, and also provides a solar cell substrate, a solar cell, and manufacturing methods therefor. Specifically, a steel foil for a solar cell substrate is characterized by containing 7% to 40% by mass of Cr and having a tensile strength of 930 MPa or more in a direction perpendicular to the rolling direction.

## Description

### [Technical Field]

The present invention relates to a steel foil for a solar cell substrate, and more particularly relates to a steel foil for a solar cell substrate with a thickness of 20 to 200µm.

### [Background Art]

Conventionally, glass has been used as a material for solar cell substrates, but in recent years, with the aim of achieving good strength and chemical resistance, bright-annealed stainless steel sheets (e.g., SUS430) with a thickness of 1 mm or less have been proposed in Patent Literatures 1 to 3 and others. Use of such stainless steel sheets as substrates makes it possible to handle the substrates in the form of coils, and consequently, solar cells have been increasingly manufactured by a continual process referred to as a "roll-to-roll process" which is advantageous in terms of mass production. Recently, in order to achieve cost reduction, stainless steel foils with a thickness of about 20 to 200 µm have been under study. For example, Patent Literature 4 proposes a stainless steel foil coated with a silica-based inorganic polymer (sol-gel silica glass) which has excellent insulation properties and thermal stability and by which a reflective layer of a back side having a concave-convex texture structure can be formed for a solar cell.

### [Citation List]

### [Patent Literature]

PTL 1: Japanese Unexamined Patent Application Publication No. 64-72571
PTL 2: Japanese Unexamined Patent Application Publication No. 5-306460
PTL 3: Japanese Unexamined Patent Application Publication No. 6-299347
PTL 4: Japanese Unexamined Patent Application Publication No. 2006-270024

### [Summary of Invention]

### [Technical Problem]

However, when a stainless steel foil such as the one described in Patent Literature 4 is used in a roll-to-roll continual process, buckling is likely to occur in the foil, and the buckling portion may run onto a roll and consequently cause wrinkles, broken surfaces, drawing, or the like, which is a problem.

It is an object of the present invention to provide a steel foil for a solar cell substrate in which buckling is unlikely to occur even when applied to a roll-to-roll continual process, and a method for manufacturing the same.

### [Solution to Problem]

The present inventors have performed thorough studies in order to achieve the object described above, and, as a result, have found that it is effective to use a steel foil which contains 7% to 40% by mass of Cr and has a tensile strength of 930 MPa or more in a direction perpendicular to the rolling direction.

The present invention has been achieved on the basis of such a finding. The present invention provides a steel foil for a solar cell substrate characterized by containing 7% to 40% by mass of Cr and having a tensile strength of 930 MPa or more in a direction perpendicular to the rolling direction.

In the steel foil for a solar cell substrate according to the present invention, preferably, the tensile strength in a direction perpendicular to the rolling direction is 1,000 MPa or more, and the microstructure retains a rolling texture. Furthermore, preferably, the coefficient of linear expansion at 0°C to 100°C is 12.0 × 10⁻⁶/°C or less, and the microstructure has a structure mainly composed of a ferrite structure.

A steel foil for a solar cell substrate according to the present invention can be manufactured by subjecting a steel sheet which contains 7% to 40% by mass of Cr and has a thickness of 1 mm or less and which has been bright-annealed or which has been annealed and pickled to cold rolling at a rolling reduction of 50% or more. In this case, preferably, the cold rolling is performed at a rolling reduction of 70% or more; the steel sheet which has been bright-annealed or which has been annealed and pickled to be used has a ferrite structure; and after the cold rolling, heat treatment is performed at 400°C to 700°C in an inert gas atmosphere.

Furthermore, the present invention provides a solar cell substrate comprising the steel foil for a solar cell substrate described above and a solar cell comprising this solar cell substrate.

Furthermore, the present invention provides a solar cell manufacturing method characterized by manufacturing a solar cell by a roll-to-roll continual process using the solar cell substrate described above. In this case, preferably, the roll-to-roll continual process includes steps of cleaning-sputtering back electrode-solar cell processing-selenization-buffer layer deposition-sputtering top electrode-electrode deposition-slitting.

### [Advantageous Effects of Invention]

According to the present invention, it is possible to manufacture a steel foil for a solar cell substrate, in which buckling is unlikely to occur even when the steel foil is applied to a roll-to-roll continual process.

### [Brief Description of Drawings]

[Fig. 1] Fig. 1 is a graph showing the relationship between the rolling reduction and the tensile strength in the direction perpendicular to the rolling direction.
[Fig. 2A] Fig. 2A shows a microstructure of the rolling texture of a SUS430 foil with a thickness of 50 µm, according to the present invention. (Rolling reduction 83%)
[Fig. 2B] Fig. 2B shows a microstructure of a material heat-treated at 700°C (in an inert gas atmosphere) of a SUS430 foil with a thickness of 50 µm, according to the present invention. (Rolling reduction 83%)
[Fig. 2C] Fig. 2C shows a microstructure of a material heat-treated at 400°C (in an inert gas atmosphere) of a SUS430 foil with a thickness of 50 µm, according to the present invention. (Rolling reduction 83%)
[Fig. 2D] Fig. 2D shows a microstructure of an annealed material (recrystallized material) of a SUS430 foil with a thickness of 50 µm, which is a conventional material (comparative material). (Rolling reduction 83%).

### [Description of Embodiments]

### 1) Steel foil for solar cell substrate

In the present invention, the steel foil used as a base material is not particularly limited as long as it has corrosion resistance required for the substrate of a solar cell. However, when the Cr content is less than 7% by mass, corrosion resistance becomes insufficient in long-term use, resulting in a problem of corrosion of the substrate. When the Cr content exceeds 40% by mass, the toughness of a hot rolled steel sheet, which is a partly-finished product in the manufacturing of the steel foil, is markedly decreased, resulting in a problem that the steel sheet cannot pass through the manufacturing line. Therefore, it is necessary to set the Cr content at 7% to 40% by mass. Examples of such a steel include SUS430 (17%Cr steel), SUS447J1 (30%Cr-2%Mo steel), 9%Cr steel, 20%Cr-5%Al steel, and SUS304 (18%Cr-8%Ni steel).

A particularly preferable composition is as follows. Note that the percentage composition of the steel means "% by mass" for each element.

### C: 0.12% or less

Since C binds to Cr in the steel to cause degradation of corrosion resistance, the C content is desirably as low as possible. However, when the C content is 0.12% or less, corrosion resistance is not significantly degraded. Therefore, the C content is preferably 0.12% or less, and more preferably 0.04% or less.

### Si: 2.5% or less

Si is an element used for deoxidation. An excessively high content of Si causes degradation of ductility. Therefore, the Si content is preferably 2.5% or less, and more preferably 1.0% or less.

### Mn: 1.0% or less

Mn binds to S to form MnS, thereby degrading corrosion resistance. Therefore, the Mn content is preferably 1.0% or less, and more preferably 0.8% or less.

### S: 0.030% or less

As described above, S binds to Mn to form MnS, thereby degrading corrosion resistance. Therefore, the S content is preferably 0.030% or less, and more preferably 0.008% or less.

### P: 0.050% or less

Since P causes degradation of ductility, the P content is desirably as low as possible. However, when the P content is 0.050% or less, ductility is not significantly degraded. Therefore, the P content is preferably 0.050% or less, and more preferably 0.040% or less.

### Cr: 7% or more and 40% or less

When the Cr content is less than 7% by mass, corrosion resistance becomes insufficient in long-term use, resulting in a problem of corrosion of the substrate. When the Cr content exceeds 40% by mass, the toughness of a hot rolled steel sheet, which is a partly-finished product in the manufacturing of the steel foil, is markedly decreased, resulting in a problem that the steel sheet cannot pass through the manufacturing line. Therefore, it is necessary to set the Cr content at 7% to 40% by mass.

Description has been made above on the essential components. In the present invention, the following elements can also be appropriately added to the steel.

### At least one selected from Nb, Ti, and Zr: 1.0% or less in total

Nb, Ti, and Zr are each an element that fixes C and N in the steel as carbides, nitrides, or carbonitrides and that is effective in improving corrosion resistance. However, when the content of the elements exceeds 1.0%, ductility is degraded markedly. Therefore, the content of the elements is limited to 1.0% or less regardless of single or combined addition. Furthermore, in order to sufficiently exert an effect of addition of these elements, the content of the elements is preferably set at 0.02% or more.

### Al: 0.20% or less

Al is an element used for deoxidation. An excessively high content of Al causes degradation of ductility. Therefore, the Al content is preferably 0.20% or less, and more preferably 0.15% or less.

### N: 0.05% or less

Since N binds to Cr in the steel to cause degradation of corrosion resistance, the N content is desirably as low as possible. However, when the N content is 0.05% or less, corrosion resistance is not significantly degraded. Therefore, the N content is preferably 0.05% or less, and more preferably 0.015% or less.

### Mo: 0.02% or more and 4.0% or less

Mo is an element that is effective in improving the corrosion resistance of the steel foil, in particular, localized corrosion. In order to obtain this effect, it is preferable to set the Mo content at 0.02% or more. On the other hand, if the Mo content exceeds 4.0%, ductility is degraded markedly. Therefore, the upper limit is preferably 4.0%, and more preferably 2.0% or less.

In addition, for the purpose of improving corrosion resistance, Ni, Cu, V, and W also may be added, each in the amount of 1.0% or less. Furthermore, for the purpose of improving hot workability, Ca, Mg, REMs (Rare Earth Metals), and B may be added, each in the amount of 0.1% or less.

The balance includes Fe and incidental impurities. Among the incidental impurities, the content of O (oxygen) is preferably 0.02% or less.

In order to manufacture a solar cell by a roll-to-roll continual process, it is necessary to subject a coil-shaped steel foil for a substrate to many steps, for example, steps of cleaning-sputtering Mo back contact-solar cell processing (absorber layer deposition)-selenization-Cds buffer layer deposition (chemical bath deposition)-sputtering top electrode-front electrode deposition-slitting. Consequently, since the steel foil for a substrate is subjected to bending and unbending by rolls a number of times, it is placed in a situation where buckling is likely to occur. In particular, if the tensile strength in a direction perpendicular to the rolling direction of the steel foil is small (soft), when the steel foil passes through rolls, wrinkles (buckling) are caused by buckling parallel to the rolling direction. In order to prevent the buckling, as described above, it is effective to increase the stiffness of the foil by setting the tensile strength in a direction perpendicular to the rolling direction of the steel foil for a substrate at 930 MPa or more, preferably 1,000 MPa or more.

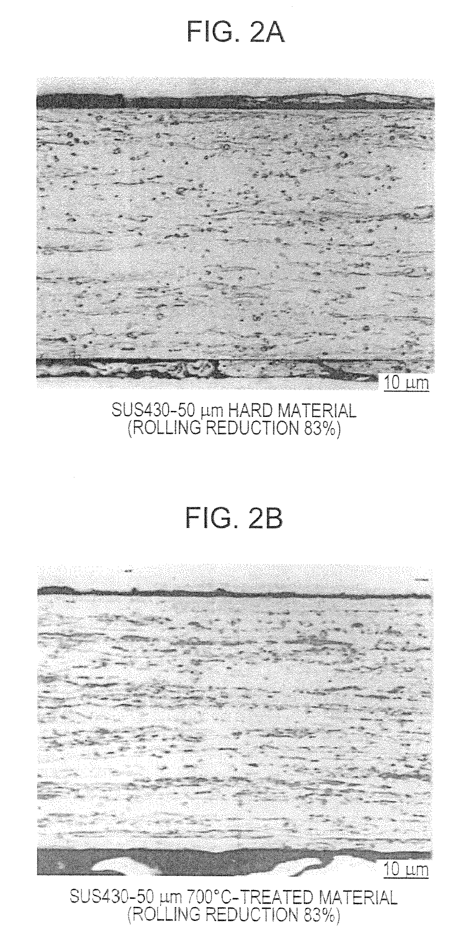

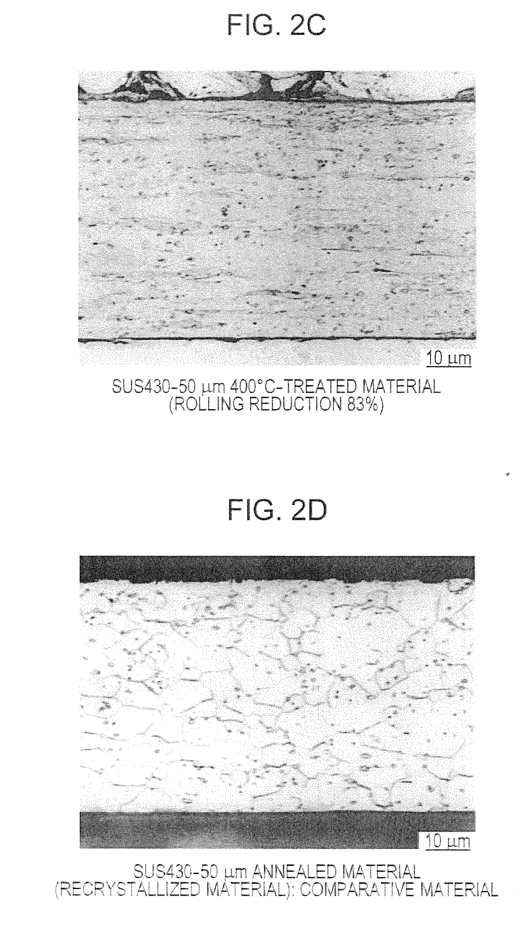

Furthermore, preferably, the microstructure retains a rolling texture, such as the one shown in each of Figs. 2A to 2C. The term "retains a rolling texture, such as the one shown in each of Figs. 2A to 2C" means having an as-cold-rolled state or having a texture obtained by performing heat treatment at 400°C to 700°C for 0 to 5 minutes in an inert gas atmosphere, in which some parts or all of the rolling texture are not recrystallized by heat treatment and remain as flat grains. The rolling texture volume fraction is 50% by volume or more, and preferably 90% by volume or more. Furthermore, Fig. 2D shows an annealed material (recrystallized material). When recrystallization is completed, the aspect ratio (major axis/minor axis) becomes almost equal to 1. The microstructures of Figs. 2A to 2D are obtained by microscope observation at a magnification of 1,000 after aqua regia etching.

Furthermore, when a steel foil of SUS304 or the like in which the coefficient of linear expansion at 0°C to 100°C exceeds 12.0 × 10⁻⁶/°C is used as a substrate, a Cu(In₁₋ₓGaₓ)Se₂ thin film (hereinafter referred to as "CIGS thin film") peels off during the manufacturing process because of a difference in coefficient of linear expansion between the CIGS thin film and the substrate, which is a problem. Therefore, the coefficient of linear expansion at 0°C to 100°C is desirably set to be 12.0 × 10⁻⁶/°C or less. In order to attain a coefficient of linear expansion of 12.0 × 10⁻⁶/°C or less at 0°C to 100°C, the steel foil preferably has a structure mainly composed of a ferrite structure, such as ferritic stainless steel, e.g., SUS430 or SUH409L, or 9mass%Cr steel having a ferrite structure. The term "structure mainly composed of a ferrite structure" refers to a structure in which the ferrite area fraction is 95% or more. The rest of the structure includes less than 5% of at least one of an austenite structure and a martensite structure.

### 2) Method for manufacturing steel foil for solar cell substrate

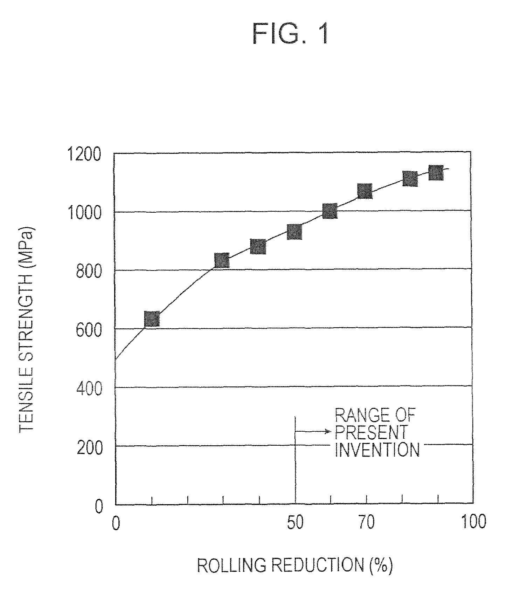

A steel foil for a solar cell substrate according to the present invention can be manufactured by subjecting a steel sheet which contains 7% to 40% by mass of Cr and has a thickness of 1 mm or less and which has been bright-annealed or which has been annealed and pickled to cold rolling at a rolling reduction of 50% or more. The reason for this is that, as shown in Fig. 1, in SUS430 or the like, when the rolling reduction is set at 50% or more, a tensile strength of 930 MPa or more can be obtained. When the rolling reduction is set at 70% or more, a tensile strength of 1,000 MPa or more can be obtained.

Furthermore, in order to obtain a steel foil having a coefficient of linear expansion of 12.0 × 10⁻⁶/°C or less at 0°C to 100°C, it is appropriate and preferable to use a steel sheet which has a ferrite structure, such as ferritic stainless steel, e.g., SUS430 or SUH409L, or 9mass%Cr steel having a ferrite structure and which has been bright-annealed or which has been annealed and pickled.

Furthermore, although the object of the present invention can be achieved by using the steel foil in an as-cold-rolled state, after the cold rolling, by performing heat treatment in an inert gas atmosphere, such as N₂ gas, AX gas (or also referred to as NH₃ cracking gas) (75vol%H₂+25vol%N₂), H₂ gas, HN gas (5vol%H₂+95vol%N₂), or Ar gas, at 400°C to 700°C for 0 to 5 minutes, a further increase in strength can be achieved, which is believed to be due to age-hardening. Thus, this is more effective in preventing buckling. Such an effect cannot be exerted at a heat treatment temperature of lower than 400°C. On the other hand, when the heat treatment temperature exceeds 700°C, softening occurs and it is not possible to obtain a tensile strength of 930 MPa or more. The heat treatment temperature is, more preferably, 400°C to 600°C.

### [EXAMPLE 1]

Cold-rolled steel sheets of SUS430(16%Cr) or 9%Cr steel having the composition shown in Table 1 with a thickness of 0.05 to 0.3 mm which had been bright-annealed were subjected to cold rolling at the rolling reduction shown in Table 2 to form steel foils with a thickness of 30 to 50 µm. The steel foils were subjected to degreasing, and then, directly or after heat treatment in a N₂ gas atmosphere at the heat treatment temperature shown in Table 2 in some of the steel foils, subjected to processing by a solar cell roll-to-roll continual process including a step of multi-source deposition or sputtering. Tensile test specimens were taken in the direction perpendicular to the rolling direction from the steel foils which had been cold-rolled or heat-treated, and tensile strength, elongation, and the Vickers hardness (Hv) of the steel foils were measured. Furthermore, occurrence of wrinkles during processing by the continual process was visually examined.

The results thereof are shown in Table 2. As is clear from Table 2, in each of the inventive examples, the tensile strength is 930 MPa or more, and there is no occurrence of wrinkles. Furthermore, it is clear that by performing heat treatment at a heat treatment temperature (400°C to 700°C), which is within the range of the present invention, the tensile strength can be increased.

### [EXAMPLE 2]

SUS430, 11%Cr-1.5%Si steel, and SUS304 each having the composition shown in Table 1 were subjected to cold rolling at the rolling reduction shown in Table 3 to form steel foils with a thickness of 30 to 50 µm. The steel foils were subjected to degreasing, and then, directly or after heat treatment in a N₂ gas atmosphere at the heat treatment temperature shown in Table 3 in some of the steel foils, subjected to processing by a solar cell roll-to-roll continual process including a step of multi-source deposition or sputtering. Tensile test specimens were taken in the direction perpendicular to the rolling direction from the steel foils which had been cold-rolled or heat-treated, and tensile strength, elongation, and the Vickers hardness (Hv) of the steel foils were measured. Tensile strength and elongation were measured according to JIS Z 2241(1998), and Hv was measured according to JIS Z 2244(1998). Furthermore, occurrence of wrinkles during processing by the continual process was visually examined. Furthermore, the peeling state of a CIGS thin film was observed visually and with a microscope. Table 3 also shows the coefficient of linear expansion at 0°C to 100°C for each steel.

The results are shown in Table 3. As is clear from Table 3, in each of the inventive examples, the tensile strength is 930 MPa or more, and there is no occurrence of wrinkles. Furthermore, it is clear that in the examples in which the coefficient of linear expansion at 0°C to 100°C is 12.0 × 10⁻⁶/°C or less, there is no occurrence of CIGS thin film peeling.
[Table 1]

**Table 1**

| | | | | | | | (mass%) | |
|---|---|---|---|---|---|---|---|---|
| Steel | C | Si | Mn | P | S | Cr | Al | Cu |
| SUS430 | 0.037 | 0.23 | 0.51 | 0.028 | 0.003 | 16.2 | - | - |
| 9%Cr | 0.006 | 0.20 | 0.20 | 0.025 | 0.005 | 9.4 | - | 0.4 |
| 11%Cr-1.5%Si | 0.008 | 1.4 | 0.51 | 0.021 | 0.006 | 11.4 | - | - |
| SUS304 | 0.05 | 0.40 | 1.0 | 0.03 | 0.006 | 18.2 | - | - |

[Table 2]

**Table 2**

| Steel | Rolling reduction (%) | Heat treatment temperature (°C) | Thickness (µm) | Tensile strength (MPa) | Elongation (%) | Hardness (Hv) | Occurrence of wrinkles | Remarks |
|---|---|---|---|---|---|---|---|---|
| SUS430 | 35 | - | 30 | 856 | 4 | 255 | Occurred | Comparative example |
| | 70 | - | 30 | 1070 | 1 | 286 | Not occurred | Inventive example |
| | 70 | 400 | 30 | 1134 | 1 | 324 | Not occurred | Inventive example |
| | 84 | 400 | 50 | 1170 | 1 | 330 | Not occurred | Inventive example |
| | 84 | 750 | 50 | 871 | 5 | 267 | Occurred | Comparative example |
| | 50 | - | 50 | 930 | 3 | 280 | Not occurred | Inventive example |
| 9%Cr | 90 | 400 | 30 | 1200 | 1 | 320 | Not occurred | Inventive example |
| | 48 | - | 30 | 929 | 1 | 264 | Occurred | Comparative example |

[Table 3]

**Table 3**

| Steel | Rolling reduction (%) | Heat treatment temperature (°C) | Thickness (µm) | Coefficient of linear expansion (×10⁶/°C) | Tensile strength (MPa) | Elongation (%) | Hardness (Hv) | Occurrence of wrinkles | Occurrence of CIGS peeling | Remarks |
|---|---|---|---|---|---|---|---|---|---|---|
| SUS430 | 70 | - | 30 | 10.7 | 1070 | 1 | 286 | Not occurred | Not occurred | Inventive example |
| | 70 | 400 | 30 | | 1134 | 1 | 324 | Not occurred | | Inventive example |
| | 84 | 400 | 50 | | 1170 | 1 | 330 | Not occurred | | Inventive example |
| | 50 | - | 50 | | 930 | 3 | 280 | Not occurred | | Inventive example |
| 11%Cr-1.5%Si | 83 | 400 | 50 | 11.4 | 1170 | 2 | 335 | Not occurred | Not occurred | Inventive example |
| SUS304 | 50 | - | 50 | 17.3 | 1200 | 1 | 320 | Not occurred | Occurred | Inventive example |

## Claims

1. A steel foil for a solar cell substrate **characterized by** comprising 7% to 40% by mass of Cr and having a tensile strength of 930 MPa or more in a direction perpendicular to the rolling direction.

2. The steel foil for a solar cell substrate according to Claim 1, **characterized in that** the tensile strength in a direction perpendicular to the rolling direction is 1,000 MPa or more.

3. The steel foil for a solar cell substrate according to Claim 1 or 2, **characterized in that** its microstructure retains a rolling texture.

4. The steel foil for a solar cell substrate according to any one of Claims 1 to 3, **characterized in that** the coefficient of linear expansion at 0°C to 100°C is 12.0 × 10⁻⁶/°C or less.

5. The steel foil for a solar cell substrate according to any one of Claims 1 to 4, **characterized in that** its microstructure has a structure mainly composed of a ferrite structure.

6. A method for manufacturing a steel foil for a solar cell substrate, **characterized by** comprising subjecting a steel sheet which contains 7% to 40% by mass of Cr and has a thickness of 1 mm or less and which has been bright-annealed or which has been annealed and pickled to cold rolling at a rolling reduction of 50% or more.

7. The method for manufacturing a steel foil for a solar cell substrate according to Claim 6, **characterized in that** the cold rolling is performed at a rolling reduction of 70% or more.

8. The method for manufacturing a steel foil for a solar cell substrate according to Claim 6 or 7, **characterized in that** the steel sheet which has been bright-annealed or which has been annealed and pickled to be used has a ferrite structure.

9. The method for manufacturing a steel foil for a solar cell substrate according to any one of Claims 6 to 8, **characterized in that**, after the cold rolling, heat treatment is performed at 400°C to 700°C in an inert gas atmosphere.

10. A solar cell substrate comprising the steel foil for a solar cell substrate according to any one of Claims 1 to 5.

11. A solar cell comprising the solar cell substrate according to Claim 10.

12. A solar cell manufacturing method **characterized by** manufacturing a solar cell by a roll-to-roll continual process using the solar cell substrate according to Claim 10.

13. The solar cell manufacturing method according to Claim 12, **characterized in that** the roll-to-roll continual process includes steps of cleaning-sputtering back electrode-solar cell processing-selenization-buffer layer deposition-sputtering top electrode-electrode deposition-slitting.
